# EUROPEAN PATENT APPLICATION

(11) **EP 4 572 108 A1**
(43) Date of publication of application: **18.06.2025**
(21) Application number: 24218815.9
(22) Date of filing: 10.12.2024
(51) Int. Cl.: H02K 11/33, H02M 7/00

(54) **AN ELECTRIC MACHINE**

(30) Priority: 15.12.2023 CN 202311732860
(71) Applicant: Valeo Japan Co., Ltd, Kumagaya-shi, Saitama 360-0193 (JP)
(72) Inventor: CHEN, Lian, Shenzhen, 518128 (CN); NIE, Chuangye, Shenzhen, 518128 (CN); ABDULLAH, Farook, 600130 Chennai (IN); RAVICHANDRAN, Sanjay, 600130 Chennai (IN); DURAIPANDI, Arumugapandian, 600130 Chennai (IN); RAJA, Antonyvinoth, 600130 Chennai (IN)
(74) Representative: Valeo Systèmes Thermiques

(57) **Abstract**

An electric machine (100) for a motor vehicle includes an electric motor (125), a machine (115) and an inverter (140). The machine (115) is driven by the electric motor (125). The inverter (140) is received and held in an inverter housing (130) and is adapted to process and regulate electrical power being supplied to the electric motor (125) from an external power source. The inverter (140) comprises a printed circuit board (141) and power transistors (142) for converting a High Voltage (HV) Direct Current (DC) to a three-phase Alternating Current (AC) that drives the electric motor (125). The inverter (140) further comprises a frame element (144) disposed between the printed circuit board (141) and a bottom wall (131a) of the front head (131). The frame element (144) is provided with urging elements (145) adapted to urge the corresponding power transistors (142) towards the bottom wall (131a).

## Description

### FIELD OF INVENTION

The present invention relates to an electric machine. More particularly, the present invention relates to an arrangement for mounting power transistors of an inverter of the electric machine to a front head.

### BACKGROUND OF THE INVENTION

Generally, an electric machine, for example, an electric driven compressor includes a compressor unit, an electric motor and an inverter. Particularly, the electric motor drives the compressor unit and the inverter regulates and supplies electrical power to the electric motor received in a motor housing. The inverter is received and held inside an inverter housing. The inverter includes a printed circuit board and various heat generating electronic components such as power transistors (for example, IGBT/MOSFET). The printed circuit board comprises holes for receiving lead frames emanating from the power transistors, the lead frames are soldered to the printed circuit board. Generally, electric power is supplied from an external power source to the printed circuit board via an electrical connector mounted on the outer side of the inverter housing. A three-phase bridge circuit consisting of the six power transistors converts a High Voltage (HV) Direct Current (DC) to a three-phase Alternating Current (AC) that drives the electric motor.

The power transistors are heated during operation thereof. The heat generated during operation of the power transistor may cause damage to the power transistor due to fusing of critical elements of the power transistors, breakage or failure of the power transistors due to reduced mechanical strength of critical elements thereof at elevated temperatures. It is required to dissipate heat from the power transistor for preventing breakage or failure of the power transistor and ensuring efficient performance of the power transistors. The power transistors are urged against a bottom wall of the inverter housing for heat dissipation from the power transistors since the bottom wall being in contact with refrigerant received in the motor accommodating space of the motor housing on other side thereof acts as a heat sink.

For proper heat dissipation from the power transistors, the power transistors are required to be positioned abutting the bottom wall and in sufficient contact with the bottom wall. Conventionally, metallic leaf spring elements are used for urging the power transistors against the bottom wall. Generally, two or more leaf springs are used for urging the six power transistors against the bottom wall. Each of the leaf spring is secured to the bottom wall by screws to urge the corresponding power transistors against the bottom wall.

The conventional arrangement for urging the power transistors against the bottom wall face serviceability issues. More specifically, such an arrangement for urging the power transistors against the bottom wall requires multiple metallic leaf springs secured on the bottom wall with the power transistors disposed between the leaf springs and the bottom wall. The mounting of the leaf springs during the assembly is inconvenient and time consuming.

Further, in case of conventional arrangement of leaf springs for urging the power transistors towards the bottom wall, it is complicated to access the power transistors for service or replacement. More specifically, accessing the power transistors requires unsoldering of lead frames from the printed circuit board, disassembling the printed circuit board from front head and thereafter dis-assembling the leaf spring from the front head. More specifically, the leaf spring being covered by the printed circuit board, it is not possible to disassemble the leaf spring to access the power transistor without disassembling the printed circuit board from the front head.

Accordingly, there is a need for an improved arrangement for urging the power transistors towards the front head that addresses serviceability issues. There is a need for an arrangement that provides convenient and quick access to the power transistors for repair, replacement and maintenance thereof. Furthermore, there is a need for an improved arrangement for simultaneously urging multiple power transistors arranged in an array against the bottom wall to achieve improved heat dissipation from the power transistors.

### SUMMARY OF THE INVENTION

An electric machine is disclosed in accordance with an embodiment of the present invention. The electric machine includes an electric motor, a machine and an inverter. The machine is driven by the electric motor. The inverter is received and held in an inverter housing that includes a front head and a cover. The inverter is adapted to process and regulate electrical power being supplied to the electric motor from an external power source. The inverter comprises a printed circuit board and multiple power transistors. The power transistors convert a High Voltage (HV) Direct Current (DC) to a three-phase Alternating Current (AC) that drives the electric motor. Further, the inverter comprises a frame element disposed between the printed circuit board and a bottom wall of the front head. The frame element is provided with urging elements adapted to urge corresponding power transistors towards the bottom wall.

Generally, the printed circuit board and the frame element are adapted to be secured to the front head of the inverter housing by means of common mounting elements.

Specifically,, the printed circuit board and the frame element comprises holes that are aligned with respect to each other in the assembled configuration of the inverter for passing the mounting elements there-through to engage with the holes formed on the front head.

Furthermore, the frame element comprises metallic bushes over-moulded with respect to the frame element, the hole is formed through the metallic bush.

Particularly, the frame element in conjunction with the urging elements is adapted to simultaneously urge multiple power transistors disposed in an array with respect to the bottom wall.

More specifically, the urging elements are aligned with respect to the corresponding power transistors and adapted to urge the corresponding power transistors against the bottom wall when the frame element and the printed circuit board are mounted to the bottom wall.

Further, the urging element comprises at least a portion thereof protruding towards the bottom wall along the plane of the frame element when assembled to the frame element.

More specifically, the urging element comprises a substantial flat portion adapted to interact with the corresponding power transistor to urge the power transistor against the bottom wall.

Preferably, the frame element is formed with socket portions aligned with respect to the corresponding power transistors being urged and adapted to receive and hold the urging elements therein.

Generally, at least one of the socket portions comprises corresponding retainer portions adapted to retain at least a portion of the urging elements within the corresponding sockets and maintain the urging elements aligned with respect to the corresponding socket portions.

More specifically, the socket portion comprises at least a pair of retainer portions disposed on opposite sides thereof.

Further, the frame element comprises holding portions extending therefrom towards the bottom wall.

Particularly, at least one pair of oppositely disposed holding portions corresponding to one socket portion are adapted to hold the corresponding power transistor aligned with respect to the socket portion and restrain relative axial movement of the power transistor with respect to the frame element

Generally, one pair of the holding portions corresponding to one power transistor is offset with respect to the adjacent other pair of holding portions for another power transistor.

Further, the frame element comprises guiding holes for receiving lead frames emanating from the corresponding power transistor and extending towards the printed circuit board to guide the lead frames to corresponding apertures formed on the printed circuit board.

Generally, the power transistors being urged by the frame element are arranged in an array, wherein a first set of power transistors and a second set of power transistors are arranged in parallel rows, the guiding holes corresponding to first set of power transistors and the second set of power transistors are separated by either one of ribs and cavities.

Further, a thermal pad is disposed between the power transistors and the bottom wall.

### BRIEF DESCRIPTION OF THE DRAWINGS

Other characteristics, details and advantages of the invention may be inferred from the description of the invention hereunder. A more complete appreciation of the invention and many of the attendant advantages thereof will be readily obtained as the same becomes better understood by reference to the following detailed description when considered in connection with the accompanying figures, wherein:
FIG. 1 illustrates a schematic representation of assembly of an electric machine in accordance with an embodiment of the present invention.
FIG. 2a illustrates an enlarged cross-sectional view of the assembly of an inverter and interaction between elements of the inverter of the electric machine of FIG. 1.
FIG. 2b illustrates an enlarged cross-sectional view depicting interaction of holding portions and an urging element with a corresponding power transistor along section A-A of FIG. 2a.
FIG. 3 illustrates an assembled view of the electric machine according to an embodiment of the present invention depicted without cover.
FIG. 4 illustrates an exploded view depicting arrangement of the various elements of the electric machine of FIG. 3 with respect to each other.
FIG. 5 illustrates an isometric view of a frame element according to an embodiment of the present invention.
FIG. 6 illustrates bottom view of the frame element of FIG. 5.
FIG. 7 illustrates the frame element depicting the offset arrangement of holding portions.
FIG. 8 illustrates an urging element in accordance with an embodiment of the present invention.
FIG. 9 shows a power transistor in accordance with an embodiment of the present invention.
FIG. 10a illustrates an assembly between multiple urging elements of FIG. 8 and the frame element of FIG. 6.
FIG. 10b illustrates an enlarged isometric view of one end of a socket portion formed with a retainer portion.
FIG. 10c illustrates an isometric view of one end of the urging element of the FIG. 8 engaged with the retainer portion of FIG. 10b.
FIG. 11a illustrates an isometric view of a frame element assembly.
FIG. 11b illustrates sectional view of the power transistor along section B-B of FIG. 11a, wherein the power transistor is depicted held by the holding portions of the frame element.
FIG. 12 illustrates an isometric view of the frame element assembly of FIG. 11a aligned with respect to a printed circuit board to configure the printed circuit board assembly to be mounted on a front head.
FIG. 13a illustrates a sectional view depicting the printed circuit board assembly of FIG. 12 positioned with respect to the front head before being mounted to the front head by using bolts.
FIG. 13b illustrates a sectional view of FIG. 13a depicting the printed circuit board assembly after being mounted to the front head by using bolts.

### DETAILED DESCRIPTION OF THE INVENTION

It must be noted that the accompanying figures disclose the invention in a detailed enough way to be implemented, said figures helping to better define the invention if needs be. The invention should however not be limited to the embodiment disclosed in the description.

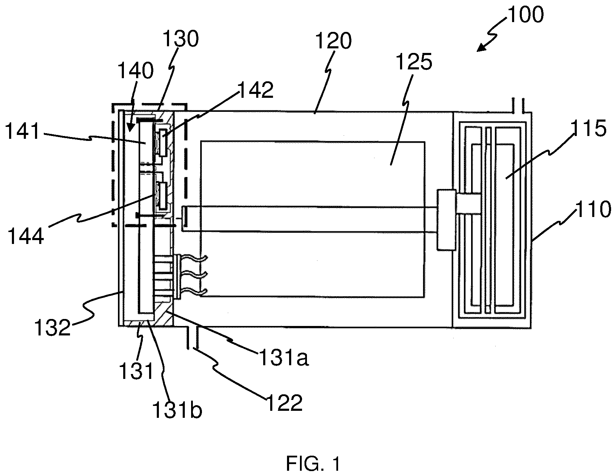

The present invention envisages an electric machine 100, particularly, an electric driven compressor. Referring to FIG. 1, a schematic representation of the electric driven compressor is illustrated. The electric driven compressor comprises a compressor unit 115, an electric motor 125 and an inverter 140.

The compressor unit 115 is received in an enclosure defined by a compressor housing 110. The compressor housing 110 is an open ended structure that includes an end wall and peripheral wall. The compressor unit 115 compresses a fluid, particularly, a refrigerant flowing through an air-conditioning loop of a vehicle air-conditioning system. The compressor unit 115 is generally a scroll type compressor. However, the present invention is not limited to any particular configuration of the compressor unit 115. The compressor housing 110 protects the compressor unit 115 against harmful external environment conditions.

The electric motor 125 is received and held in a motor housing 120. The electric motor 125 drives the compressor unit 115. In accordance with an embodiment, the motor housing 120 is also an open ended structure that includes an end wall and peripheral wall disposed along a periphery of the end wall. The electric motor 125 is functionally coupled to and drives the compressor unit 115.

The motor housing 120 is open ended separate housing arranged between the compressor housing 110 and an inverter housing 130. In one arrangement an open end of the motor housing 120 is abutting a bottom wall 131a of a front head 131 or closed end of the inverter housing 130 and the end wall or closed end of the motor housing 120 is abutting open end of the compressor housing 110 to define separate enclosures for receiving the electric motor 125 and the compressor unit 115.

Alternatively, the closed ends or end walls of the motor housing 120 and the inverter housing 130 are abutting each other and the open ends of the motor housing 120 and the compressor housing 110 are abutting each other to define a common enclosure for the electric motor 125 and the compressor unit 115.

In accordance with yet another embodiment, the motor housing 120 and the front head 131 of the inverter housing 130 are formed integrally with two open ends opposite to each other and a common wall between the front head 131 and the motor housing 120. The first open end is closed by the open end of the compressor housing 110 to define a common enclosure for the electric motor 125 and the compressor unit 115. The second open end is closed by a cover 132 to define the enclosure for receiving an inverter 140.

However, the present invention is not limited to any particular configuration and arrangement of the compressor housing 110, the motor housing 120 and the inverter housing 130 as far as the these housings 110, 120, 130 are capable of enclosing the compressor unit 115, the electric motor 125 and the inverter 140 to protect these against harmful external environment conditions.

Further, the motor housing 120 is provided with an inlet port 122 for sucking refrigerant gas from the air-conditioning loop. The sucked refrigerant gas passing through the inlet port 122 is of low pressure and low temperature. The low pressure refrigerant gas flows inside the motor housing 120 and is sucked by the compressor unit 115.

The inverter 140 is received and held in the inverter housing 130. The inverter housing 130 is generally of larger radial dimension compared to the motor housing 120 at least a portion of the inverter housing 130 extends beyond the motor housing 120 to provide space for mounting of at least one electrical connector (not shown) to the inverter housing 130.

The inverter housing 130 comprises the front head 131 and the cover 132. The front head 131 is an open-ended housing that includes the bottom wall 131a and a peripheral wall 131b disposed along a periphery of the bottom wall 131a. As mentioned above, the inverter housing 130 abuts the end of the motor housing 120. More specifically, the bottom wall 131a of the front head 131 abuts the end of the motor housing 120, and hence is cooled by the low-pressure refrigerant gas which passes through the motor housing 120, thereby functioning as a heat sink.

The front head 131 and the cover are assembled together to define an enclosure that receives components, particularly electronic components composing the inverter 140 such as for example a printed circuit board 141 to safeguard the electronic components from harmful external environment. The cover 132 is removable with respect to the front head 131 for accessing the components received in the front head 131 for service and maintenance.

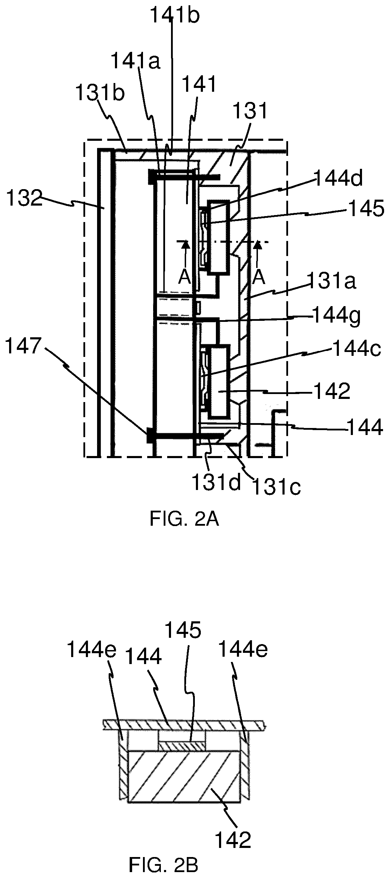

FIG. 2a illustrates an enlarged cross-sectional view of the assembly of the inverter 140. The inverter 140 further comprises multiple power transistors 142 (also referred to as semiconductors or IGBTs or MOSFETs) for converting a High Voltage (HV) Direct Current (DC) to a three-phase Alternating Current (AC) that drives the electric motor 125. In addition, the inverter 140 comprises a frame element 144 secured to the bottom wall 131a of a front head 131 of the inverter housing 130 between the printed circuit board 141 and the bottom wall 131a. In the assembled state, the frame element 144 and the printed circuit board 141 being coupled to each other are mounted together to the front head 131 by means of mounting elements, preferably, mounting bolts 147. The frame element 144 is formed with multiple socket portions 144c adapted to receive multiple urging elements 145. The frame element 144 in conjunction with the metallic urging elements 145 received in the socket portions 144c formed in the frame element 144 is adapted to simultaneously urge multiple power transistors 142 disposed in an array with respect to the bottom wall 131a. The urging elements 145 ensures exerting sufficient urging force on the power transistors 142 to urge the power transistors 142 against the bottom wall 131a. The frame element 144 further comprises guiding holes 144g for receiving lead frames 142b emanating from the corresponding power transistor 142 and extending towards the printed circuit board 141 to guide the lead frames 142b to corresponding apertures 141b formed on the printed circuit board 141.

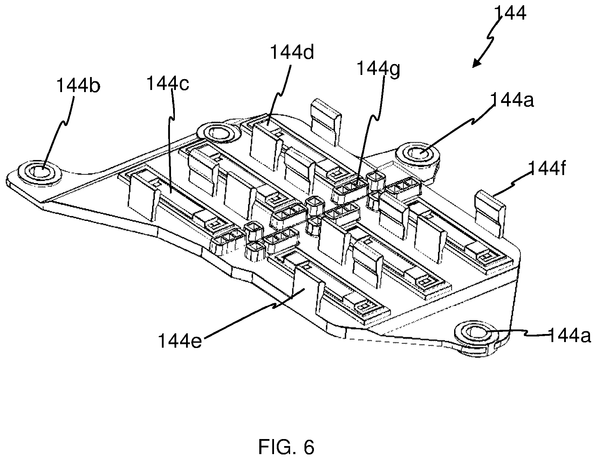

FIG. 2b illustrates an enlarged cross-sectional view of the inverter along section line A-A illustrated in FIG. 2a. Referring to the FIG. 6, the frame element 144 comprises at least one socket portion 144c adapted to receive at least one urging element 145. The frame element 144 further comprises at least one pair of holding portion 144e and a set of guiding holes 144g corresponding to each power transistor 142 to be urged by the urging element 145. Generally, the holding portions 144e are disposed opposite to each other and extend from the frame element 144 towards the bottom wall 131a. The holding portions 144e are adapted to hold corresponding power transistors 142 and restrains relative axial movement of the power transistors 142 with respect to the frame element 144.

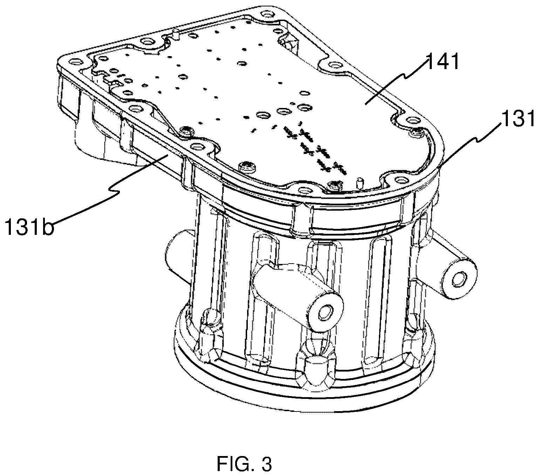

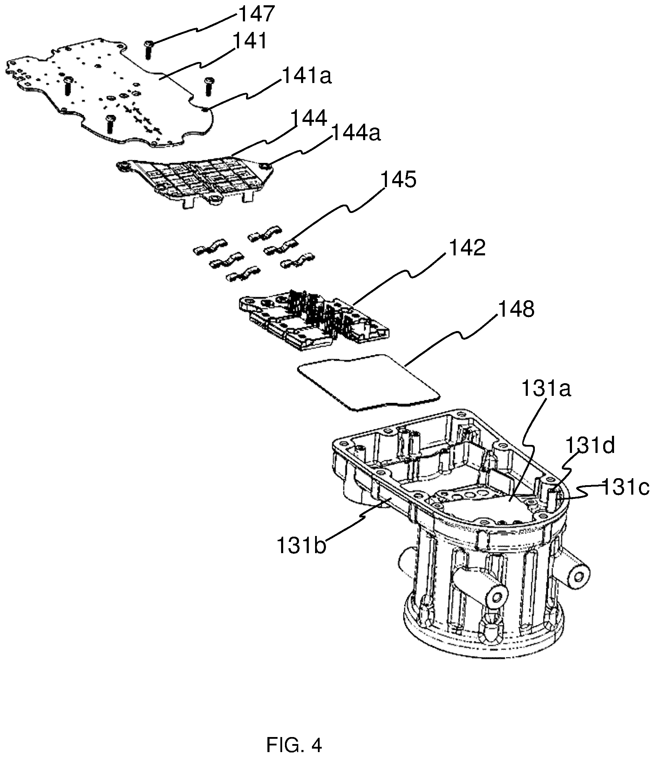

FIG. 3 illustrates the inverter 140 without the cover 132 to depict the internal details of the inverter 140. The inverter 140 includes the inverter housing 130 that receives and holds the printed circuit board 141, the power transistors 142 and a frame element 144. FIG. 4 illustrates an exploded view of the inverter 140 depicting arrangement of the various elements thereof with respect to each other.

The printed circuit board 141 is having a planar structure with electric components mounted thereon on side of the printed circuit board 141 facing the bottom wall 131a in the assembled configuration of the printed circuit board 141 and the frame element 144 with respect to the bottom wall 131a.

The lead frames 142b emanating from a casing 142a of the power transistors 142 are received in the apertures 141b formed on the printed circuit board 141 for being secured to the printed circuit board 141 by soldering. Such electrical coupling between the printed circuit board 141 and the power transistors 142 configures supply of DC high voltage power, low voltage signals and AC output between the power transistors 142 and the PCB 141. The power transistors 142 convert a High Voltage (HV) Direct Current (DC) to a three-phase Alternating Current (AC) that drives the electric motor 125.

The frame element 144 and the printed circuit board 141 are secured to the bottom wall 131a of the front head 131 of the inverter housing 130. The frame element 144 is disposed between the printed circuit board 141 and the bottom wall 131a. The frame element 144 and the printed circuit board 141 is mounted to the front head 131 by means of the mounting bolts 147. The bottom wall 131a of the front head 131 comprises columns 131c extending from the bottom wall 131a with mounting holes 131d formed thereon for mounting the frame element 144 and the printed circuit board 141 to the front head 131. Particularly, the mounting bolts 147 pass through aligned holes 144a formed on the frame element 144, the holes 141a formed on the printed circuit board 141 and engage with mounting holes 131d formed on the columns 131c to mount the frame element 144 and the printed circuit board 141 to the bottom wall 131a of the front head 131. Although, in the present description and accompanying drawings, the mounting of the frame element 144 and the printed circuit board 141 to the front head 131 is by means of the mounting bolts 147, however, any other means can be used for mounting the frame element 144 and the printed circuit board 141 to the front head 131.

Preferably, the frame element 144 and the printed circuit board 141 are coupled to each other in overlapping manner, wherein the frame element 144 is overlapped by at least a portion of the printed circuit board 141. The present invention is not limited to any particular means for coupling the frame element 144 to the printed circuit board 141. The frame element 144 and the printed circuit board 141 being coupled to each other are mounted together to the front head 131 by means of mounting elements, preferably, the mounting bolts 147. Such coupling between the frame element 144 and the printed circuit board 141 makes the assembly and dis-assembly of the inverter quick and convenient as the frame element 144 and the printed circuit board 141 can be assembled and dis-assembled from the front head 131 together, thereby enhancing the serviceability. The frame element 144 is disposed parallel to the bottom wall 131a and between the printed circuit board 141 and the bottom wall 131a and abutting the printed circuit board 141. With such configuration, the printed circuit board 141 urges the frame element 144 against the bottom wall 131a, thereby causing the urging elements 144 held in the socket portions 144c to urge the components disposed between the frame element 144 and the bottom wall 131a towards the bottom wall 131a as the frame element 144 and the printed circuit board 141 are mounted on the bottom wall 131a.

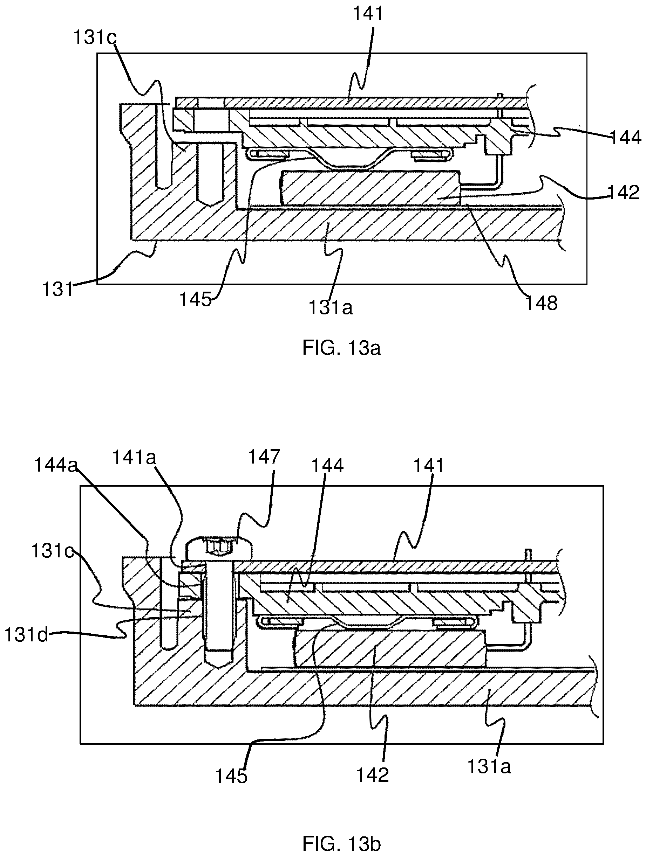

Referring to FIG. 13a, a thermal interface material 148 is disposed between the power transistors 142 and the bottom wall 131a. In accordance with an embodiment of the present invention, the thermal interface material 148 is a thermal pad. The thermal pad 148 improves heat transfer between the power transistors 142 and bottom wall 131a of the front head 131, thereby improving heat dissipation from the power transistors 142 and preventing damage to the power transistors 142 due to overheating. The frame element 144 urges the power transistors 142 against the thermal pad 148 mounted on the bottom wall 131a. In accordance with another embodiment of the present invention, the thermal interface material can be at least one of gap filler and lamina of polyamide material. The lamina of polyamide material acts as insulation between the power transistors 142 and the bottom wall 131a to prevent charge flow through the air gaps inherently formed in the gap filler.

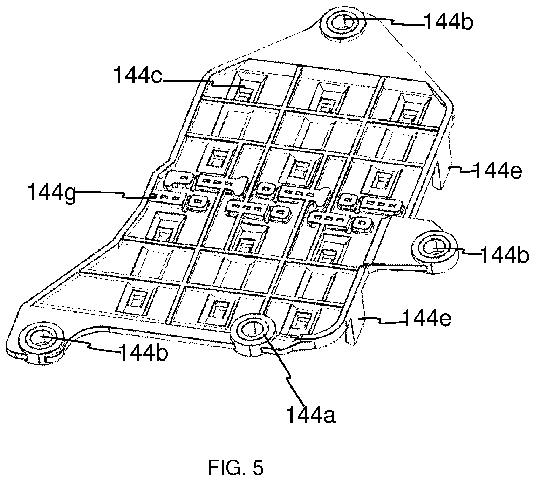

In accordance with one embodiment, the frame element 144 is having a planar structure as depicted in FIG. 5 and FIG. 6. The frame element 144 is of plastic material. The frame element 144 comprises metallic bushes 144b formed with holes 144a, the socket portions 144c formed with retainer portions 144d, the holding portions 144e formed with latching portions 144f and the guiding holes 144g.

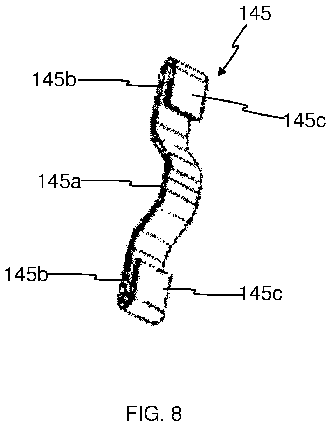

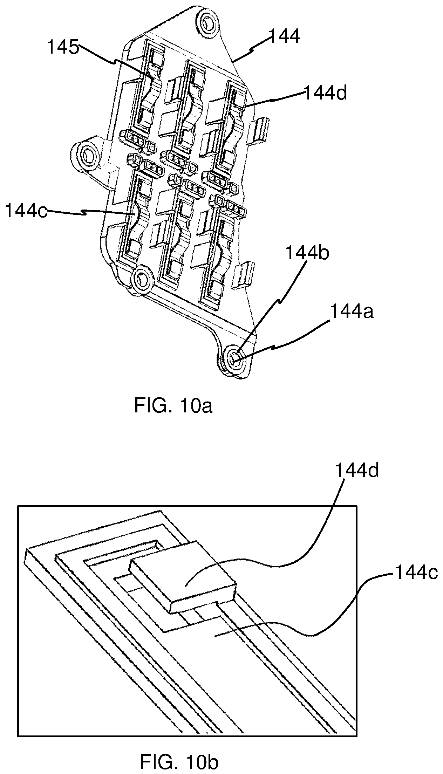

The socket portions 144c are depressions formed on the frame element 144, extend along the length of the frame element 144 and are adapted to receive urging elements 145 therein. The socket portions 144c are formed on the face of the frame element 144 facing the bottom wall 131a in the assembled configuration of the frame element 144 and the printed circuit board 141 with respect to the bottom wall 131a. Each socket portion 144c is adapted to receive and hold at least one urging element 145 as illustrated in FIG. 8 therein, urging element 145 urges the corresponding power transistor 142 towards the bottom wall 131a when the frame element 144 and the printed circuit board 141 are mounted in the front head 131. At least one of the socket portions 144c comprises the retainer portions 144d as illustrated in the FIG. 10b extending inwardly from at least a portion of the periphery thereof and adapted to retain at least a portion of the corresponding urging element 145 within the socket portion 144c. Particularly, the socket portion 144c comprises at least a pair of retainer portions 144d disposed on opposite ends thereof. The socket portions 144c are arranged in an array corresponding to the array of the power transistors 142 to be urged against the bottom wall 131a. The present invention is not limited to any particular configuration, number and placement of the socket portions 144c as far as the socket portions 144c are capable of receiving and holding at least a portion of the corresponding urging elements 145 aligned with respect to the corresponding power transistors 142 for urging the power transistors 142 against the bottom wall 131a for heat dissipation therefrom.

Each holding portion 144e extending from the frame element 144 comprises a fixed end and a free end opposite to the fixed end. The fixed end is integral with and extends from the frame element 144. The holding portions 144e are formed with the frame element 144 during injection moulding of the frame element 144. The holding portion 144e comprises a latching portion 144f formed at the free end thereof adapted to engage with a recessed portion 142d formed on a corresponding side of the power transistor 142. The latching portions 144f of the opposite holding portions 144e engage with the recessed portions 142d formed on the opposite sides of the power transistor 142 to securely hold the power transistor 142. With such configuration, the power transistor 142 can be urged against the bottom wall 131a by the corresponding urging element 145 while being held by the holding portions 144e. Since the holding portions 144e are all integrally formed with the frame element 144 during the moulding of the frame element 144, the holding portions 144e are also of plastic material.

The set of guiding holes 144g for a corresponding power transistor 142 allows passage of the lead frames 142b emanating from the power transistor 142 and extending towards the printed circuit board 141. The inner dimension of the guiding holes 144g is configured to be slightly larger than the external dimension of the lead frames 142b. Further, a chamfer is formed on each the guiding holes 144g to guide the lead frames 142b to the corresponding apertures 141b formed on the printed circuit board 141. The power transistors 142 being urged by the frame element 144 and the urging element 145 are arranged in an array, wherein the first set of power transistors 142 and a second set of power transistors 142 are arranged parallel to each other in different rows. The guiding holes 144g for the first set of power transistors 142 are arranged parallel to and opposite to the guiding holes 144g for the second set of the power transistors 142. Further, the guiding holes 144g corresponding to the first set of power transistors 142 and the second set of power transistors 142 are separated by either one of ribs and cavities. Such configuration of ribs and cavities increases the creepage distance between the lead frames 142b passing through the oppositely arranged guiding holes 144g, thereby protecting against short circuiting.

The metallic bushes 144b are over-moulded with respect to the frame element 144 and adapted receive mounting bolts 147 for mounting the frame element 144 and the printed circuit board 141 to the front head 131. The metallic bushes 144b are disposed along the periphery of the frame element 144 and spaced apart from each other. Such mounting arrangement ensures that the urging forces are uniformly applied on the frame element 144 for improved urging of the frame element 144 against the bottom wall 131a, thereby urging of the power transistors 142 against the bottom wall 131a by the urging elements 145 when the frame element 144 and the printed circuit board 141 are mounted to the front head 131.

Generally, at least one of the socket portions 144c comprises the retainer portions 144d. Particularly, the socket portion 144c comprises at least a pair of retainer portions 144d disposed on opposite ends thereof. The retainer portions 144d are in the form of tabs that engage with the end portions of the corresponding urging element 145. The retainer portions 144d are adapted to retain at least a portion of the urging elements 145 within the corresponding socket portion 144c. More specifically, the retainer portions 144d are adapted to maintain the urging elements 145 aligned with respect to the corresponding socket portions 144c and the power transistors 142.

The plurality of urging elements 145 received and held in the corresponding socket portions are aligned with respect to the corresponding power transistors 142 arranged in an array.

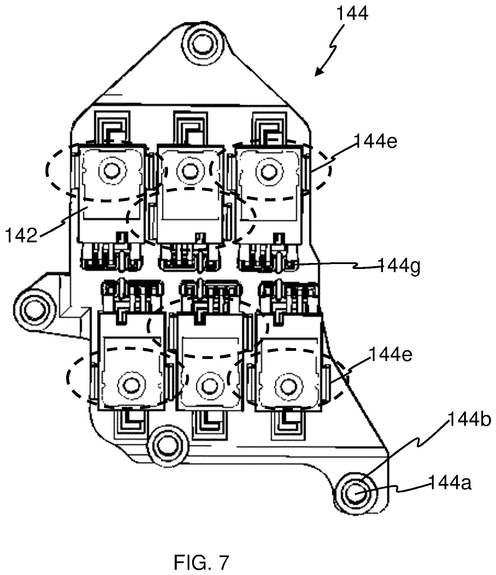

FIG. 7 shows the frame element 144 depicting the offset arrangement of the holding portions 144e. The holding portions 144e extend from the frame element 144 towards the bottom wall 131a in the assembled configuration of the frame element 144 and the printed circuit board 141 with respect to the front head 131. At least two holding portions 144e are arranged along opposite sides of the corresponding socket portion 144c receiving the urging element 145. Generally, one holding portion 144e is disposed along each of the opposite sides of the socket portion 144c receiving and holding the urging element 145 therein. With such configuration of the holding portions 144e, the power transistor 142 is held from opposite sides thereof. The two holding portions 144e arranged on opposite sides of the power transistor 142 are either aligned with respect to each other or arranged offset/staggered with respect to each other considering space constraints. Further, one pair of holding portions 144e corresponding to one socket portion 144c receiving and holding the urging element 145 therein is offset/staggered with respect to the adjacent pair of holding portions 144e corresponding to the adjacent socket portion 144c holding and receiving another urging element 145. The holding portions 144e can be configured along any two opposite sides of the corresponding socket portion144c. More specifically, the opposite holding portions 144e securely hold the corresponding power transistor 142 and restrain relative axial movement of the power transistor 142 with respect to the frame element 144 along a direction orthogonal to the bottom wall 131a. The holding portions 144e hold the respective power transistors 142 aligned with corresponding urging elements 145 that urge the power transistors 142 towards the bottom wall 131a when the frame element 144 and the printed circuit board 141 are mounted on the front head 131. Further, the opposite holding portions 144e securely holds the corresponding power transistor 142 and restricts relative angular movement of power transistor 142 with respect to the frame element 144. However, the present invention is not limited to any particular configuration, number, placement and orientation of the holding portions 144e as far as the holding portions 144e are capable of holding the power transistors 142 in aligned configuration with respect to the urging elements 145 received in the corresponding socket portions 144c.

FIG. 8 illustrates the urging element 145 in accordance with an embodiment of the present invention. The urging element 145 is in the form of a bended metal strip formed by stamping. Preferably, the urging element 145 is of spring steel or any other material exhibiting spring properties. The urging elements 145 of metal are capable of withstanding high stresses due to the printed circuit board 141 urging the frame element 144 and the frame element 144 pushing the urging elements 145 against the bottom wall 131a for urging the power transistors 142 against the bottom wall 131a. The urging element 145 comprises a channel portion 145a and side portions 145b, wherein the channel portion 145a is disposed at the centre and the side portions 145b are disposed on opposite sides of the channel portion 145a. The side portions 145b of the urging element 145 are formed with engagement elements 145c adapted to engage with the corresponding retainer portions 144d formed in the socket portion 144c to retain at least a portion of the urging element 145 aligned with respect to the socket portion 144c, particularly, within the corresponding socket portion 144c. The channel portion 145a facing the bottom wall 131a comprises a substantially flat portion that extends out of the socket portion 144c and interacts with the corresponding power transistor 142 to push the power transistor 142 against the bottom wall 131a. In accordance with another embodiment, the urging element 145 is aligned with respect to the socket portion 144c and disposed outside the socket portion 144c to urge the corresponding power transistor 142 against the bottom wall 131a. The urging elements 145 are aligned with respect to the corresponding power transistors 142 and adapted to simultaneously urge the corresponding power transistors 142 against the bottom wall 131a when the frame element 144 and the printed circuit board 141 are mounted to the bottom wall 131a. Specifically, at least a portion of the urging element 145 protruding towards the bottom wall 123 along the plane of the frame element 144 urges the corresponding power transistor 142 towards the bottom wall 131a when the frame element 144 and the printed circuit board 141 are assembled to the front head 131.

The urging elements 145 received in the socket portions 144c pushes corresponding power transistors 142 against the bottom wall 131a of the front head 131 for heat dissipation from the power transistor 142 as the frame element 144 and the printed circuit board 141 is mounted on the front head 131. In accordance with another embodiment, the urging elements 145 are integrally formed with the frame element 144 based on the arrangement of the power transistors 142 to be positioned and urged against the bottom wall 131a for heat dissipation from the power transistors 142. In another embodiment, the urging elements 145 separate from the frame element 144 and received in the socket portions 144c configured on the frame element 144 in parallel rows to simultaneously interact with the corresponding power transistors 142 arranged in parallel rows. However, the present invention is not limited to any particular configuration, placement, orientation and number of the urging elements 145 as far as the urging elements 145 are capable of simultaneously urging the multiple power transistors 142 against the bottom wall 131a. With such configuration of the frame element 144 provided with multiple urging elements 145, the frame element 144 is adapted to simultaneously urge the multiple power transistors 142 arranged in an array with respect to the bottom wall 131a. Further, with such configuration of the frame element 144 provided with the multiple urging elements 145 and the frame element 144 urged against the bottom wall 131a by the printed circuit board 141, the frame element 144 is adapted to evenly distribute the urging force on the power transistors 142 to prevent damage to the power transistors 142 due to stress concentration caused by excessive urging forces.

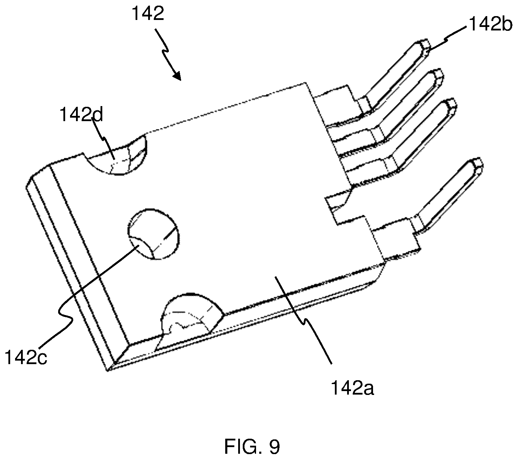

FIG. 9 shows the power transistor 142 in accordance with an embodiment of the present invention. The power transistors 142 includes a plurality of switching elements that are moulded in the casing 142a. The switching elements include the lead frames 142b that protrude out of the casing 142a and are connected to the printed circuit board 141. Each of the power transistor 142 includes four lead frames 142b emanating there from. Further, the recessed portions 142d are formed above and on both sides of the casing 142a of the power transistor 142. The recessed portions 142d are adapted to engage with the latching portion 144f formed at the free end of the holding portion 144e. At least one of the power transistor 142 further includes at least one positioning hole 142c formed thereon and adapted to engage with corresponding positioning pin formed on the frame element 144 for positioning the power transistor 142 with respect to the frame element 144 and prevent sliding of the power transistor 142 relative to the frame element 144.

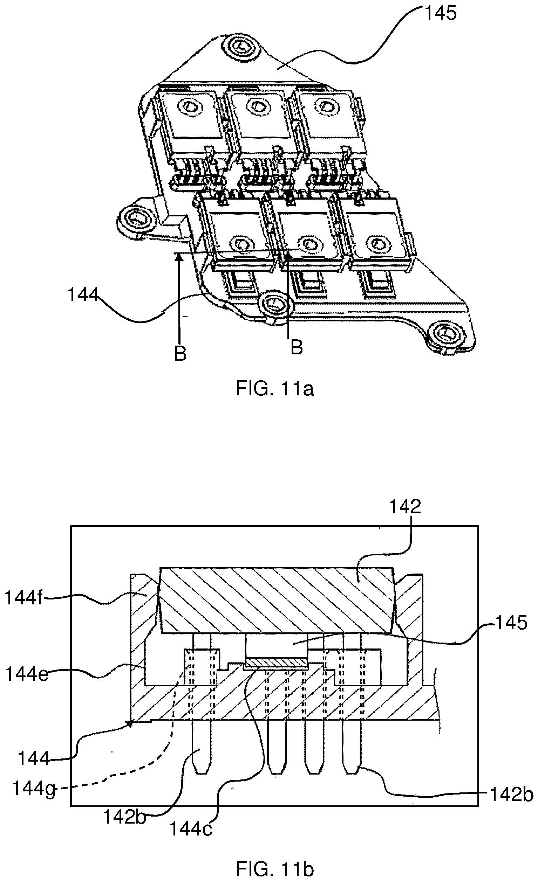

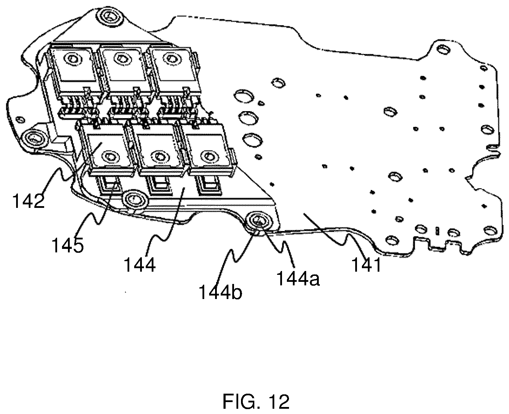

Referring to FIG. 10a-10c and FIG. 11a-11b the frame element 144 and portions thereof during various steps involved in the assembling processes of assembling the urging elements 145 and the power transistors 142 to the frame element 144 are illustrated. Referring to FIG. 12 the frame element 144 with, the urging elements 145 and the power transistors 142 assembled thereto and aligned with the printed circuit board 141 is depicted. Referring to FIG. 13a and 13b, the frame element 144 and the printed circuit board 141 while the frame element 144 and the printed circuit board 141 are being mounted to the front head 131 of the inverter housing 130 in accordance with an embodiment of the present invention are illustrated.

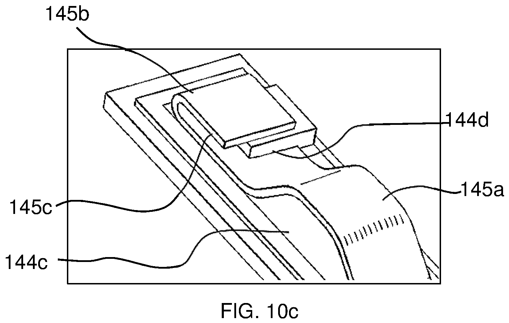

Primarily, as shown in FIG. 10a, the urging elements 145 are depicted assembled in the socket portions 144c formed on the frame element 144. As depicted in FIG. 10b, the retainer portion 144d is a tab extending inwardly from a portion of the periphery of the socket portion 144c to hang over the base plane of the socket portion 144c. The urging element 145 is secured to the socket portion 144c by the retainer portion 144d by engagement between engaging portions 145c of the urging element 145 and the retainer portion 144d as shown in FIG. 10c.

As illustrated in FIG. 11a, 11b, after assembling the urging elements 145 on the frame element 144, the power transistors 142 are disposed on the corresponding urging elements 145 and secured by latching portions 144f. The lead frames 142b emanating from the power transistors 142 are guided through the corresponding guiding holes 144g formed in the frame element 144. The frame element 144 assembled with the urging elements 145 and the power transistors 142 configures a frame element assembly.

In the next step, as shown in FIG. 12, the frame element assembly comprising the frame 144, the urging elements 145, and the power transistors 142 is disposed on the printed circuit board 141 so that the lead frames 142b pass through the corresponding apertures 141b formed on the printed circuit board 141. The frame element 144 is fixed to the printed circuit board 141 by rivets (not shown). In another embodiment, the frame element 144 is fixed to the printed circuit board 141 by other measures such as clips formed with the frame element 144 which engage with the periphery of the printed circuit board 141. The printed circuit board 141 assembled with the frame element assembly configures a printed circuit board assembly.

Then, the printed circuit board assembly comprising the printed circuit board 141, frame element 144, and the power transistors 142 is mounted on the front head 131. In one embodiment, a thermal pad 148 is disposed on the bottom wall 131a of the front head 131. At this stage, the power transistors 142 abuts with the bottom wall 131a via the thermal pad 148 but the frame element 144 doesn't contact with the front head 131 since the height of the column 131c is set to be smaller than the sum of a thickness of the thermal pad 148, a thickness of the power transistor 142 and a free length of the urging element 145 and a height of the corresponding step of the frame element 144, as illustrated in FIG. 13a.

Finally, the printed circuit board assembly is secured to the front head 131 by the mounting bolts 147 which pass through the holes 141a of the printed circuit board 141, the holes 144a formed on metallic bushes 144b of the frame element 144 and engage with the mounting holes 131d of the front head 131, as shown in FIG. 13b. The mounting bolts 147 pushed the printed circuit board assembly till the frame element 144 abuts the end of the column 131c against the spring force of the urging element 145. The compressed urging elements 145 urge the corresponding power transistor 142 towards the bottom wall 131a of the front head 131.

After the printed circuit board assembly is assembled in the front head 131, the lead frames 142b of the power transistor 142 passing through and extending out of the apertures 141b of the printed circuit board 141 are soldered to ensure the electric connection between the power transistor 142 and the electric patter on the printed circuit board 141.

### LIST OF REFERENCE NUMERALS

### Reference numeral Description

- 100: electric machine
- 110: compressor housing
- 115: compressor unit
- 120: motor housing
- 122: inlet port
- 125: motor
- 130: inverter housing
- 131: front head
- 131a: bottom wall
- 131b: peripheral wall
- 131c: column
- 131d: mounting hole
- 132: cover
- 140: inverter
- 141: printed circuit board
- 141a: hole
- 141b: aperture
- 142: power transistor
- 142a: casing
- 142b: lead frame
- 142c: positioning hole
- 142d: recessed portion
- 144: frame element
- 144a: hole
- 144b: metallic bush
- 144c: socket portion
- 144d: retainer portion
- 144e: holding portion
- 144f: latching portion
- 144g: guiding hole
- 145: urging element
- 147: mounting bolt
- 148: thermal pad

## Claims

1. An electric machine (100) comprising:
• an electric motor (125);
• a machine (115) driven by the electric motor (125);
• an inverter (140) received and held in an inverter housing (130) comprising a front head (131) and adapted to process and regulate electrical power being supplied to the electric motor (125) from an external power source, wherein the inverter (140) comprising:
∘ a printed circuit board (141); and
∘ multiple power transistors (142) for converting a High Voltage (HV) Direct Current (DC) to a three-phase Alternating Current (AC) that drives the electric motor (125),
**characterized in that** the inverter (140) further comprising a frame element (144) disposed between the printed circuit board (141) and a bottom wall (131a) of the front head (131), wherein the frame element (144) is provided with urging elements (145) adapted to urge the corresponding power transistors (142) towards the bottom wall (131a).

2. The electric machine (100) as claimed in claim 1, wherein the printed circuit board (141) and the frame element (144) are adapted to secured to the front head (131) of the inverter housing (130) by means of common mounting elements (147).

3. The electric machine (100) as claimed in the previous claim, wherein the printed circuit board (141) and the frame element (144) comprises holes (141a, 144a) that are aligned with respect to each other in the assembled configuration of the inverter (140) for passing the mounting elements (147) there-through to engage with the mounting holes (131d) formed on the front head (131).

4. The electric machine (100) as claimed in the previous claim, wherein the frame element (144) further comprises metallic bushes (144b) over-moulded with respect to the frame element (144), and the hole (144a) is formed through the metallic bush (144b).

5. The electric machine (100) as claimed in any of the preceding claims, wherein the frame element (144) in conjunction with the urging elements (145) is adapted to simultaneously urge the multiple power transistors (142) disposed in an array with respect to the bottom wall (131a).

6. The electric machine (100) as claimed in any of the preceding claims, wherein the urging elements (145) are aligned with respect to the corresponding power transistors (142) and adapted to urge the power transistors (142) against the bottom wall (131a) when the frame element (144) and the printed circuit board (141) are secured to the bottom wall (131a).

7. The electric machine (100) as claimed in the previous claim, wherein the urging element (145) comprises at least a portion thereof protruding towards the bottom wall (131a) along the plane of the frame element (144) when assembled to the frame element (144).

8. The electric machine (100) as claimed in any of the preceding claims, wherein the urging element (145) comprises a substantial flat portion adapted to interact with the power transistor (142).

9. The electric machine (100) as claimed in any of the preceding claims, wherein the frame element (144) is formed with socket portions (144c) aligned with respect to the corresponding power transistors (142) being urged and adapted to receive the urging elements (145) therein.

10. The electric machine (100) as claimed in the previous claim, wherein at least one of the socket portions (144c) comprises retainer portions (144d) adapted to retain at least a portion of the urging elements (145) within the corresponding socket portions (144c) and maintain the urging elements (145) aligned with respect to the corresponding socket portions (144c).

11. The electric machine (100) as claimed in the previous claim, wherein the socket portion (144c) comprises at least a pair of retainer portions (144d) disposed on opposite sides thereof.

12. The electric machine (100) as claimed in any of the preceding claims, wherein the frame element (144) comprises holding portions (144e) extending therefrom towards the bottom wall (131a).

13. The electric machine (100) as claimed in the previous claim, wherein at least one pair of oppositely disposed holding portions (144e) corresponding to one socket portion (144c) are adapted to hold the corresponding power transistor (142) aligned with respect to the socket (144c) and restrict relative axial movement of the power transistor (142) with respect to the frame element (144).

14. The electric machine (100) as claimed in the previous claim, wherein one pair of the holding portions (144e) is offset with respect to the adjacent other pair of holding portions (144e)

15. The electric machine (100) as claimed in any of the preceding claims, wherein the frame element (144) still further comprises guiding holes (144g) for receiving lead frames (142b) emanating from the corresponding power transistor (142) and extending towards the printed circuit board (141) to guide the lead frames (142b) to corresponding apertures (141b) formed on the printed circuit board (141).
